# EUROPÄISCHE PATENTSCHRIFT

(11) **EP 4 032 688 B1**
(45) Veröffentlichungstag und Bekanntmachung des Hinweises auf die Patenterteilung: **11.10.2023**
(21) Anmeldenummer: 22152065.3
(22) Anmeldetag: 18.01.2022
(51) Int. Cl.: B29C 64/135, B29C 64/277, B33Y 10/00, B33Y 30/00, G03F 7/00, G03F 7/20, B33Y 70/00, G03F 7/027, G03F 7/031, G03F 7/105, G03F 7/029

(54) **VERFAHREN UND VORRICHTUNG ZUM HERSTELLEN EINES DREIDIMENSIONALEN OBJEKTS IN EINEM OPTISCH REAKTIVEN AUSGANGSMATERIAL**
METHOD AND DEVICE FOR PRODUCING A THREE-DIMENSIONAL OBJECT IN AN OPTICALLY REACTIVE STARTING MATERIAL
PROCÉDÉ ET DISPOSITIF DE FABRICATION D'UN OBJET TRIDIMENSIONNEL DANS UNE MATIÈRE DE BASE OPTIQUEMENT RÉACTIVE

(30) Priorität: 20.01.2021 DE 102021101164
(43) Veröffentlichungstag der Anmeldung: 27.07.2022
(73) Patentinhaber: Xolo GmbH, 12489 Berlin (DE)
(72) Erfinder: Regehly, Martin, 12589 Berlin (DE)
(74) Vertreter: Hafner & Kohl PartmbB

(56) Entgegenhaltungen:
- WO-A1-2020/028431

## Beschreibung

Die Erfindung betrifft ein Verfahren und eine Vorrichtung zum Herstellen eines dreidimensionalen Objekts in einem optisch reaktiven Ausgangsmaterial.

### Hintergrund

Ausgangsmaterialien können optisch bearbeitet werden, also mittels Einstrahlen von Licht einer oder mehrerer Wellenlängen auf das Ausgangsmaterial, um wenigstens eine Materialeigenschaft des Ausgangsmaterials hierdurch zu verändern. So ist es beispielsweise als solches bekannt, mit Hilfe einer solchen optischen Bearbeitung ein Ausgangsmaterial auszuhärten. Auf diese Weise können in dem Ausgangsmaterial dreidimensionale Objekt oder Körper hergestellt werden. Aus dem Dokument WO 2009 / 014501 A1 ist ein Verfahren der Zwei-Photonen-Stereolithografie bekannt. Zwei-Photonen-Stereolithographie kann unter Verwendung eines photohärtbaren Materials durchgeführt werden, das ein Poly(meth)acrylat mit einer (Meth) Acrylatfunktionalität von mindestens drei und einem Molekulargewicht (MW) von mindestens 650, ein Urethan(meth)acrylat mit einer (Meth) Acrylatfunktionalität von 2 bis 4 und einem MW von 400 bis 10.000, ein Di(meth)acrylat aus Bisphenol A oder Bisphenol F, und ein Fotoinitiator ist. Ein Lichtstrahl wird auf einen Fokusbereich des Materials fokussiert, um eine Zwei-Photonen-Absorption von Licht einer einzelnen Wellenlänge im Fokusbereich und damit eine Polymerisation des Materials im Fokusbereich zu induzieren. Der Strahl wird gemäß einem vorgewählten Muster über das Material gescannt, so dass der Strahl auf verschiedene vorgewählte Bereiche fokussiert wird, um die Polymerisation des Materials in den vorgewählten Bereichen zu induzieren.

Aus dem Dokument EP 1 616 344 A1 ist ein Verfahren zum räumlich hochaufgelösten Erzeugen einer dauerhaften Struktur bekannt. Zum räumlich hochaufgelösten Erzeugen einer dauerhaften Struktur wird eine Substanz, die mit einem optischen Signal veränderbar ist, in einem Schreibbereich bereitgestellt. Das optische Signal wird so auf den Schreibbereich aufgebracht, dass es einen räumlich begrenzten Teilbereich gezielt auslässt, in dem dauerhaft ein anderer Zustand der Substanz eingestellt wird, als in von dem optischen Signal erfassten Teilbereichen des Schreibbereichs. Hierbei ist der von dem optischen Signal gezielt ausgelassene Teilbereich ein lokales Intensitätsminimum des optischen Signals. Das optische Signal wird außerhalb des gezielt ausgelassenen räumlich begrenzten Teilbereichs so aufgebracht, dass beim Verändern der Substanz mit dem optischen Signal die Sättigung erreicht wird. Auf diese Weise kann die Beugungsgrenze bei der erzeugten Struktur unterschritten werden.

Im Dokument WO 01 / 71431 A1 ist ein Verfahren zum holografischen Aufzeichnen mittels ultraschneller Zwei-Photonen-Fotopolymerisation bekannt. Ein Verfahren und photoaktive Medien zur holographischen Aufzeichnung und Mikro- / Nanofabrikation von optischen und biooptischen Strukturen durch gleichzeitige Absorption von zwei Photonen durch die photoaktiven Medien, um eine gleichzeitige photochemische Änderung in Bereichen konstruktiver Interferenz innerhalb eines holographischen Musters zu induzieren, werden offenbart. Der photochemische Polymerisationsprozess, der aus der gleichzeitigen Absorption von zwei Photonen resultiert, kann zur Mikrofabrikation von mikro- und nanoskaligen Merkmalen, zur Speicherung holographischer Daten und zur Bildung schaltbarer Beugungsgitter verwendet werden. In einem Beispiel wird eine holographische Konfiguration mit zwei Strahlen in einem Aufbau mit verschiedenen Optiken verwendet.

Im Dokument DE 10 2014 008 994 B3 sind Zwei-Photonen-Polymerisations-Initiatoren für die Anwendung in organischen Lösungsmitteln bekannt.

In Dokument DE 10 2016 007 736 A1 ist ein Verfahren zur lokalen Modifikation eines Substrats offenbart, bei dem eine Substratanordnung bereitgestellt wird, die Wirkmoleküle in dem Substrat oder in unmittelbarer Nachbarschaft dazu aufweist. Die Wirkmoleküle sind durch Absorption einer ersten Wellenlänge von einem Grundzustand photonisch in einen ersten angeregten Zustand und durch Absorption einer zweiten Wellenlänge von ihrem ersten angeregten Zustand photonisch in einen zweiten angeregten Zustand anregbar, wobei von dem zweiten angeregten Zustand ein spontaner, strahlungsloser Abregungspfad existiert. Durch Absorption einer dritten Wellenlänge sind die Wirkmoleküle von ihrem ersten angeregten Zustand unter Abgabe stimulierter Emission in ihren Grundzustand abregbar. Das Verfahren umfasst weiterhin Folgendes: Erzeugen von drei Laserstrahlen der genannten Wellenlängen, wobei das Profil des dritten Laserstrahls einen Null-Intensitätsbereich aufweist und die zeitliche Koordination der Laserstrahlen so erfolgt, dass Wirkmoleküle durch Absorption des ersten Laserstrahls photonisch in ihren ersten angeregten Zustand angeregt werden, außerhalb des Null-Intensitätsbereichs unter stimulierter Emission wieder in ihren Grundzustand abgeregt werden und innerhalb des Null-Intensitätsbereichs photonisch in ihren zweiten angeregten Zustand angeregt und unter Abgabe das Substrat lokal modifizierender, thermischer Energie strahlungslos abgeregt werden.

Im Dokument US 5 325 324 A wird ein dreidimensional optischer Speicher beschrieben, dessen Inhalt über fokussierte Laserimpulse einer ersten Wellenlänge geschrieben wird und über fokussierte Laserimpulse einer zweiten Wellenlänge ausgelesen wird. Um eine Anregung nur im Fokusvolumen zu erzeugen, wird die nichtlineare Zwei-Photonen-Absorption genutzt.

Im Dokument US 2014 / 0145093 A1 ist ein Verfahren zur Fluoreszenzmikroskopie (Stimulated Emission Depletion - STED) offenbart, bei dem ein Laserstrahl erster Wellenlänge im Arbeitsvolumen einen ersten Fokuspunkt generiert. Dieser regt die Fluoreszenz des untersuchten Materials an. Über das gleiche Objektiv wird ein Laserstrahl zweiter Wellenlänge eingestrahlt, der einen donutförmigen, zweiten Fokus erzeugt, welcher mit dem ersten überlappt und die Fluoreszenz in den Ausbereichen des ersten Fokus abregt. Hierdurch ergibt sich ein kleinerer leuchtender Bereich als die Beugungsgrenze des ersten Fokus.

Dokument US 2011 / 0039213 A1 offenbart ein Verfahren, bei dem ein fokussierter Laserstrahl erster Wellenlänge einen Fotoinitiator anregt. Mittels zeitlich kurz danach eingestrahltem Laserlicht zweiter Wellenlänge mit einem donutförmigen Fokus kann der Fotoinitiator aus dem Zwischenzustand selektiv abgeregt werden (STED-Prozess). Durch geometrischen Versatz des Fokuspunktes der zweiten Wellenlänge kann die Breite des mit der ersten Wellenlänge anregten Fokuspunktes reduziert werden.

Im Dokument WO 2017 / 106187 A1 ist ein Verfahren beschrieben, bei dem ein fokussierter Laserstrahl erster Wellenlänge einen Fotoinitiator in einen Zwischenzustand anregt. Mittels einer zweiten Wellenlänge kann der Fotoinitiator aus dem Zwischenzustand selektiv abgeregt werden. So kann die Breite des mit der ersten Wellenlänge anregten Fokuspunktes reduziert werden. Mit einem dritten fokussierten Laserstrahl werden die noch im Zwischenzustand befindlichen Moleküle in einen Endzustand angeregt, von dem aus die lokale Polymerisation des Ausgangsmaterials gestartet wird. Das Verfahren ist für die Strukturierung von Photoresists zum Beispiel für Halbleiterfertigung ausgelegt.

Im Dokument DE 10 2016 007 736 A1 ist ein Verfahren zur lokalen Modifikation eines Substrats offenbart, bei dem ein fokussierter Laserstrahl erster Wellenlänge einen Fotoinitiator in einen Zwischenzustand anregt. Mit einem zweiten fokussierten Laserstrahl werden die noch im Zwischenzustand befindlichen Moleküle in einen weiteren, höher angeregten Zustand überführt, von dem aus ein Großteil der Anregungsenergie in Form von thermischer Energie an die lokale Umgebung abgegeben wird. wodurch eine temperaturinduzierte Modifikation des Substrats bewirkt wird, zum Beispiel eine Polymerisation. Mittels einer dritten Wellenlänge kann der Fotoinitiator aus dem Zwischenzustand durch stimulierte Emission selektiv abgeregt werden (STED-Prozess). So kann die Breite des mit der ersten Wellenlänge anregten Fokuspunktes reduziert werden.

Im Dokument WO 2020 / 245456 A1 sind ein Verfahren und eine Vorrichtung zum lokalen Polymerisieren eines optischen aktiven Ausgangsmaterials mittels Zwei-Farben-Polymerisation (Dual-Color-Polymerization, Absorption von Licht unterschiedlicher Wellenlängen) sowie deren Nutzung zum Herstellen eines dreidimensionalen Objekts bekannt.

Im Dokument US 2019 / 0047224 A1 sind ein Verfahren und eine Vorrichtung zum Herstellen eines strukturierten Objekts offenbart, wobei ein lichthärtbares Material, das durch Bestrahlung mit Licht gehärtet wird, innerhalb aufeinanderfolgender Schichten mit Licht bestrahlt wird.

Dokument DE 10 2015 100 731 A1 offenbart eine optische Formvorrichtung und ein optisches Formverfahren zum Formen einer dreidimensionalen Struktur mittels Wiederholen eines Vorgangs zum Ausbilden einer ausgehärteten Harzschicht durch Bestrahlen einer optisch aushärtenden Harzflüssigkeit mit Licht, so dass ausgehärtete Harzschichten laminiert werden.

Im Dokument US 2017 / 0021455 A1 sind Systeme und Verfahren zur additiven Mehrstrahlfertigung offenbart, welche mehrere Lichtstrahlen verwenden, um Schichten von Pulvermaterial in ausgewählten Bereichen freizulegen, bis das Pulvermaterial zu Voxeln verschmilzt, die Aufbauschichten einer dreidimensionalen Struktur bilden.

Das Dokument WO 2020 / 028 431 A1 offenbart Verfahren und Systeme für holographische 3D-Lithographie, mit welcher ein 3D-Drucken von verschiedenen Formen ermöglicht wird. Insbesondere ist die Verwendung von Zwei-Photonen-Lithographie offenbart.

### Zusammenfassung

Aufgabe der Erfindung ist es, ein Verfahren und eine Vorrichtung zum Herstellen eines dreidimensionalen Objekts in einem optisch reaktiven Ausgangsmaterial abzugeben, mit denen dreidimensionale Objekte mit beliebiger äußerer Form mit hoher räumlicher Auflösung herstellbar sind.

Zur Lösung sind ein Verfahren und eine Vorrichtung zum Herstellen eines dreidimensionalen Objekts in einem optisch reaktiven Ausgangsmaterial nach den unabhängigen Ansprüchen geschaffen. Ausgestaltungen sind Gegenstand von abhängigen Unteransprüchen.

Nach einem Aspekt ist ein Verfahren zum Herstellen eines dreidimensionalen Objekts in einem optisch reaktiven Ausgangsmaterial geschaffen, welches Folgendes aufweist: Bereitstellen eines optisch reaktiven Ausgangsmaterial in einem Arbeitsvolumen, wobei das optisch reaktive Ausgangsmaterial Wirkmoleküle eines Zwei-Farben-Fotoinitiators enthält; und optisches Bearbeiten des Ausgangsmaterials zum Herstellen eines dreidimensionalen Objekts in dem Arbeitsvolumen mittels Einstrahlen von Licht einer ersten Wellenlänge und Licht einer zweiten Wellenlänge, die von der ersten Wellenlänge verschieden ist, wobei das Licht erster Wellenlänge und das Licht zweiter Wellenlänge von einer Beleuchtungseinrichtung bereitgestellt werden. Das optische Bearbeiten umfasst hierbei Folgendes: a) Einstrahlen des Lichts erster Wellenlänge durch eine Öffnung einer einem Objektiv vorgelagerten Eintrittspupille und das Objektiv hindurch, wobei das Objektiv das Licht erster Wellenlänge in dem Ausgangsmaterial in ein Fokusvolumen in einem Fokus des Objektivs fokussiert, so dass Wirkmoleküle, die das Licht erster Wellenlänge absorbieren, in einen Zwischenzustand übergehen; b) Einstrahlen des Lichts zweiter Wellenlänge über die Eintrittspupille und das Objektiv, wobei das Objektiv das Licht zweiter Wellenlänge in dem Ausgangsmaterial in das Fokusvolumen fokussiert, so dass innerhalb des Fokusvolumens Wirkmoleküle, die in dem Zwischenzustand sind und das Licht zweiter Wellenlänge absorbieren, in einen reaktiven Zustand übergehen und hierdurch in dem Fokusvolumen eine chemische Reaktion ausgelöst wird, durch die eine Materialeigenschaft des Ausgangsmaterial lokal verändert wird; und c) Herstellen des dreidimensionalen Objekts, indem die Schritte a) und b) für weitere Fokusvolumen, die von dem Fokusvolumen verschieden sind, wiederholt werden. Das Licht erster Wellenlänge und das Licht zweiter Wellenlänge werden beim Einstrahlen auf dem Weg zum Fokusvolumen hin zumindest beim Durchgang durch die Eintrittspupille und beim Durchgang durch das Objektiv räumlich nicht überlappend und in dem Fokusvolumen räumlich überlappend eingestrahlt.

Nach einem weiteren Aspekt ist eine Vorrichtung zum Herstellen eines dreidimensionalen Objekts in einem optisch reaktiven Ausgangsmaterial geschaffen, welche Folgendes aufweist: ein Arbeitsvolumen, welches eingerichtet ist, ein optisch reaktives Ausgangsmaterial aufzunehmen, wobei das optisch reaktive Ausgangsmaterial Wirkmoleküle eines Zwei-Farben-Fotoinitiators enthält; eine Beleuchtungseinrichtung, die eingerichtet ist, Licht einer ersten Wellenlänge und Licht einer zweiten Wellenlänge, die von der ersten Wellenlänge verschieden ist, zum Einstrahlen auf das Arbeitsvolumen bereitzustellen; ein Objektiv, welches eingerichtet ist, das Licht erster Wellenlänge und das Licht zweiter Wellenlänge in ein Fokusvolumen in einem Fokus des Objektivs in dem optisch reaktive Ausgangsmaterial einzustrahlen; und eine Eintrittspupille, welche dem Objektiv in Lichteinfallsrichtung vorgelagert ist, derart, dass das Licht erster Wellenlänge und das Licht zweiter Wellenlänge durch eine Öffnung der Eintrittspupille zu dem Objektiv gelangen. Das Licht erster Wellenlänge und das Licht zweiter Wellenlänge sind beim Einstrahlen auf dem Weg zum Fokusvolumen hin zumindest beim Durchgang durch die Eintrittspupille und beim Durchgang durch das Objektiv räumlich nicht überlappend und in dem Fokusvolumen räumlich überlappend einstrahlbar. Die Beleuchtungseinrichtung, die Eintrittspupille und das Objektiv sind weiterhin eingerichtet, das Ausgangsmaterial in dem Arbeitsvolumen zum Herstellen eines dreidimensionalen Objekts wie folgt optisch zu bearbeiten: a) Einstrahlen des Lichts erster Wellenlänge durch die Eintrittspupille und das Objektiv hindurch, wobei das Objektiv das Licht erster Wellenlänge in dem Ausgangsmaterial in das Fokusvolumen fokussiert, so dass Wirkmoleküle, die das Licht erster Wellenlänge absorbieren, in einen Zwischenzustand übergehen; b) Einstrahlen des Lichts zweiter Wellenlänge über die Eintrittspupille und das Objektiv, wobei das Objektiv das Licht zweiter Wellenlänge in dem Ausgangsmaterial in das Fokusvolumen fokussiert, so dass innerhalb des Fokusvolumens Wirkmoleküle, die in dem Zwischenzustand sind und das Licht zweiter Wellenlänge absorbieren, in einen reaktiven Zustand übergehen und hierdurch in dem Fokusvolumen eine chemische Reaktion ausgelöst wird, durch die eine Materialeigenschaft des Ausgangsmaterial lokal verändert wird; und c) Herstellen des dreidimensionalen Objekts, indem die Schritte a) und b) für weitere Fokusvolumen, die von dem Fokusvolumen verschieden sind, wiederholt werden.

Mithilfe des Verfahrens und der Vorrichtung ist es ermöglicht, kleinste Fokusvolumen in dem Ausgangsmaterial getrennt und nacheinander optisch zu bearbeiten, beispielsweise zu härten oder auszuhärten, um so nach und nach das dreidimensionale Objekt oder den dreidimensionalen Artikel herzustellen. Der Fokus des Objektivs, in welchem sich das Licht erster Wellenlänge und das Licht zweiter Wellenlänge in dem Ausgangsmaterial lokal (im Fokusvolumen) räumlich überlappen, wird nach und nach durch das Ausgangsmaterial bewegt, um so das Objekt mit der dreidimensionalen Form oder Struktur herzustellen. Wirkmoleküle des Zwei-Farben-Fotoinitiators werden nur im Fokusvolumen aus dem Zwischenzustand in den reaktiven Zustand gebracht, da nur dort das Licht erster Wellenlänge und das Licht zweiter Wellenlänge auf die Wirkmoleküle in zeitlich genügend kurzem Abstand nacheinander und / oder zeitlich überlappend eingestrahlt wird, derart, dass der Übergang in den reaktiven Zustand mittels Absorption des Lichts zweiter Wellenlänge aus dem Zwischenzustand stattfindet, bevor die Wirkmoleküle aus diesem Zwischenzustand relaxieren, welcher seinerseits von den Wirkmolekülen aufgrund der Absorption des Lichts erster Wellenlänge erreicht wurde.

Das Licht erster Wellenlänge und das Licht zweiter Wellenlänge können eine Öffnungsfläche der Öffnung der Eintrittspupille jeweils etwa hälftig ausfüllend eingestrahlt werden. Bei dieser Ausführungsform kann die Öffnungsfläche der Öffnung der Eintrittspupille beispielsweise in zwei Halbkreise unterteilt sein, die jeweils vom Licht erster Wellenlänge oder vom Licht zweiter Wellenlänge erfasst werden. Alternativ kann vorgesehen sein, dass die Öffnungsfläche der Öffnung der Eintrittspupille nur zum Teil von dem Licht erster Wellenlänge und dem Licht zweiter Wellenlänge erfasst wird, sodass zumindest ein Teilbereich der Öffnungsfläche vom Licht nicht erfasst ist (freibleibend).

Das Licht erster Wellenlänge und das Licht zweiter Wellenlänge können eine Querschnittsfläche eines Lichtdurchgangs des Objektivs jeweils etwa hälftig ausfüllend (erfassend) eingestrahlt werden. In Verbindung mit der Querschnittsfläche des Lichtdurchgangs des Objektivs gelten die vorangehend im Zusammenhang mit der Öffnungsfläche der Öffnung der Eintrittspupille gemachten Erläuterungen zu Ausgestaltungsvarianten entsprechend.

Das Fokusvolumen sowie die weiteren Fokusvolumen können jeweils mit einer räumlichen Ausdehnung ausgebildet werden, die kleiner oder gleich der Beugungsgrenze für das Licht erster Wellenlänge und das Licht zweiter Wellenlänge in Verbindung mit einer beim Einstrahlen des Lichts erster Wellenlänge und des Lichts zweiter Wellenlänge verwendeten Apertur des Objektivs ist.

Das Licht erster Wellenlänge kann als polarisiertes Licht erster Wellenlänge eingestrahlt werden. In einer Ausgestaltung ist das Licht erster Wellenlänge linear polarisiert.

Das Licht zweiter Wellenlänge kann als polarisiertes Licht zweiter Wellenlänge eingestrahlt werden. In einer Ausgestaltung ist das Licht zweiter Wellenlänge linear polarisiert.

Das Licht erster Wellenlänge und / oder das Licht zweiter Wellenlänge können mit einer ortsabhängigen Polarisation eingestrahlt werden. Bei der ortsabhängigen Polarisation ist die lokale Polarisation in unterschiedlichen Bereichen einer Lichtstrahlquerschnittsfläche (quer zur Lichtausbreitungsrichtung) innerhalb des jeweiligen Lichtstrahls für das Licht erster Wellenlänge und / oder das Licht zweiter Wellenlänge verschieden. Es kann eine ortsabhängig rotierende Polarisation für das Licht erster und / oder zweiter Wellenlänge vorgesehen sein. Die Polarisation des Lichts erster und zweiter Wellenlänge kann während des zeitlichen Ablaufs der Prozessierung des Ausgangsmaterials verändert / angepasst werden.

Das Licht erster Wellenlänge und / oder das Licht zweiter Wellenlänge können mit einer räumlich im Wesentlichen homogenen Intensitätsverteilung in das Fokusvolumen eingestrahlt werden. Alternativ kann das Licht erster Wellenlänge und / oder das Licht zweiter Wellenlänge mit einer räumlich im Wesentlichen inhomogenen Intensitätsverteilung eingestrahlt werden, beispielsweise einer Gauß-förmigen Intensitätsverteilung quer zur Einstrahlrichtung.

Das Licht erster Wellenlänge und / oder das Licht zweiter Wellenlänge können als gepulstes Licht (Lichtimpulse) eingestrahlt werden. Alternativ kann das Licht erster Wellenlänge und / oder zweiter Wellenlänge als nicht-gepulstes Licht (Dauerstrich) eingestrahlt werden.

Das Ausgangsmaterial kann beim optischen Bearbeiten aufgrund der chemischen Reaktion zumindest im Bereich des Fokusvolumens sowie der weiteren Fokusvolumen ausgehärtet oder gehärtet werden.

Die durch die Wirkmoleküle im reaktiven Zustand ausgelöste chemische Reaktion kann eine polychrome Mehrphotonen-Polymerisation aufweisend ausgeführt werden. Mittels des optischen Bearbeitens kann in dem Ausgangsmaterial eine polychrome Mehrphotonen-Polymerisation ("xolography") ausgelöst werden, welche die Veränderung der wenigstens einen Materialeigenschaft des Ausgangsmaterials bewirkt. Bei einer beispielhaften Ausgestaltung kann das Ausgangsmaterial einen oder mehrere der folgenden Stoffe umfassen:

| Stoff | Strukturformel | Anteil an zum Beispiel 27,1g Ausgangsmaterial insgesamt |
|---|---|---|
| Zwei-Farben-Fotoinitiator | 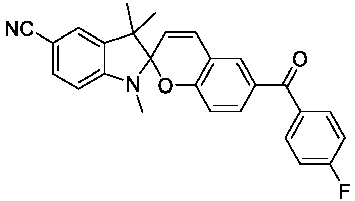 | 2 mg |
| Pentaerythritol-tetraacrylate (Monomer) | 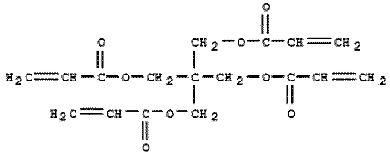 | 25,6g (21,5 ml) |
| Triethanolamin | 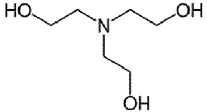 | (0,73g (1 ml) |
| Ethanol | 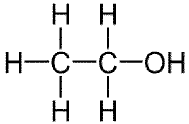 | (0,79g (1 ml) |

Auf ihrem Einstrahlweg von der jeweiligen Lichtquelle zum Fokusvolumen hin sind die Strahlen für das Licht erster Wellenlänge und das Licht zweiter Wellenlänge zumindest beim Durchgang durch die Eintrittspupille und beim Durchgang durch das Objektiv räumlich nicht überlappend ausgebildet. Es kann vorgesehen sein, dass die Strahlen auch in weiteren Abschnitten des Einstrahlwegs zum Fokusvolumen hin räumlich separiert sind, zum Beispiel zwischen der Eintrittspupille und dem Objektiv und / oder nach dem Durchgang durch das Objektiv, wahlweise bis hin zu einer im Wesentlichen ausschließlichen Überlappung nur im Fokusvolumen selbst und wahlweise hierzu lokal vorgelagerten Bereichen außerhalb des lokalen Fokusvolumens und benachbart hierzu.

Die vorangehend im Zusammenhang mit dem Verfahren beschriebenen Ausgestaltungen können in Verbindung mit der Vorrichtung zum Herstellen des dreidimensionalen Objekts entsprechend vorgesehen sein.

### Beschreibung von Ausführungsbeispielen

Im Folgenden werden weitere Ausführungsbeispiele unter Bezugnahme auf Figuren einer Zeichnung näher erläutert. Hierbei zeigen:
- Fig. 1: eine schematische Darstellung einer Vorrichtung zum Herstellen eines dreidimensionalen Objekts in einem optisch reaktiven Ausgangsmaterial, welches Wirkmoleküle eines Zwei-Farben-Fotoinitiators enthält;
- Fig. 2.1 bis 2.5: schematische Darstellungen für ein erstes Ausführungsbeispiel;
- Fig. 3.1 bis 3.5: schematische Darstellungen in Verbindung mit einem zweiten Ausführungsbeispiel;
- Fig. 4.1 bis 4.5: schematische Darstellungen in Verbindung mit einem dritten Ausführungsbeispiel und
- Fig. 5.1 bis 5.5: schematische Darstellungen in Verbindung mit einem vierten Ausführungsbeispiel.

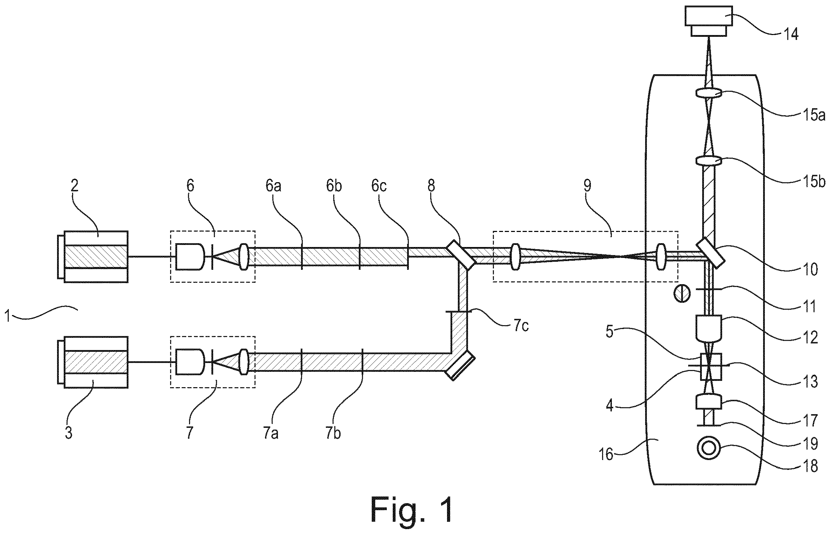

Fig. 1 zeigt eine schematische Darstellung einer Vorrichtung zum Herstellen eines dreidimensionalen Objekts oder Körpers in einem optisch reaktiven Ausgangsmaterial. Hierzu weist eine Beleuchtungseinrichtung 1 eine erste Lichtquelle 2 und eine zweite Lichtquelle 3 auf, die beispielsweise als Laserlichtquellen ausgebildet sind. Die erste und die zweite Lichtquelle 2, 3 stellen Licht einer ersten Wellenlänge und Licht einer zweiten Wellenlänge zur Verfügung, um diese auf ein optisch reaktives Ausgangsmaterial 4 in einem Aufnahmevolumen 5 einzustrahlen.

Hierbei gelangen das Licht erster Wellenlänge und das Licht zweiter Wellenlänge über ein erstes System optischer Komponenten 6 und ein zweites System optischer Komponenten 7. Im Folgenden werden die Strahlen des Lichts erster Wellenlänge und des Lichts zweiter Wellenlänge in einem Strahlkombinierer 8 zusammengeführt und durchlaufen dahinter ein Teleskop 9, um hierauf auf einen Strahlteiler 10 zu treffen. Von dort gelangt das Licht erster Wellenlänge und das Licht zweiter Wellenlänge über eine Eintrittspupille 11 in ein Objektiv 12, welches das Licht erster Wellenlänge und das Licht zweiter Wellenlänge in das Ausgangsmaterial 4 in dem Aufnahmevolumen 5 fokussiert, welches seinerseits auf einer xyz-Verstelleinrichtung 13 angeordnet ist.

Das System erster optischer Komponenten 6 und das System zweiter optischer Komponenten 7 umfassen in einer Ausgestaltung jeweils einen räumlichen optischen Filter sowie ein Element zur Strahlaufweitung. Dem jeweiligen System optischer Komponenten 6, 7 im Strahlengang nachgelagert sind ein Halbwellen-Retarder (HWP) 6a, 7a zur Rotation der Polarisationsebene des Lichtstrahls.

Weiterhin sind Aperturblenden 6c, 7c vorgesehen, um die Lichtstrahlen zu begrenzen oder aufzuteilen, zum Beispiel hälftig (50 / 50 Prozent). Alternativ kann eine Aufteilung 40 / 60 Prozent oder 30 / 70 Prozent vorgesehen sein.

Zwischen der Kamera 14 und dem Strahlteiler 10 sind zwei Linsen 15a, 15b angeordnet.

Das Objektiv 12 ist bei dem gezeigten Ausführungsbeispiel in einem Mikroskop 16 angeordnet, welches einen Kondensor 17 sowie eine Kondensorbeleuchtung 18 und einen hierzwischen angeordneten Filter 19 aufweist. Bei der Vorrichtung in Fig. 1 ist eine Kamera 14 vorgesehen, die dazu dient, die Prozessierung des Ausgangsmaterials 4 durch das Mikroskop 16 zu beobachten. Das Mikroskop 16 kann als Durchlicht- oder Auflichtmikroskop ausgeführt sein. Die Beobachtung der Prozessierung des Ausgangsmaterials 4 kann im Hell- oder Dunkelfeld ausgeführt sein.

Die Linse 15a ist eine Tubuslinse zum Erzeugen eines Zwischenbilds im Unendlich-Strahlengang des Mikroskops 16. Die Linse 15b sorgt für eine Abbildung des Zwischenbilds auf einen Sensor der Kamera 14. Wahlweise können weitere Filter zwischen Strahlteiler 10 und Linse 15a angeordnet werden, um die Prozessierung des Ausgangsmaterials 4 ohne Störung durch reflektiertes oder gestreutes Licht der ersten und der zweiten Wellenlänge beobachten zu können.

Auf dem Einstrahlweg von dem Strahlteiler 10 durch die Eintrittspupille 11 und das Objektiv 12 bis hin zum Fokus des Objektivs 12 werden das Licht erster Wellenlänge und das Licht zweiter Wellenlänge räumlich getrennt geführt, sodass keine Überlappung der beiden Lichtstrahlen besteht. Erst im Fokus des Objektivs 12 überlappen das Licht erster Wellenlänge und das Licht zweiter Wellenlänge räumlich in einem Fokusvolumen (räumlicher Überlappungsbereich). Hierdurch werden Wirkmoleküle des Zwei-Farben-Fotoinitiators in dem Ausgangsmaterial 4 zunächst in einen Zwischenzustand überführt, indem das Licht erster Wellenlänge von diesen Wirkmolekülen absorbiert wird. Wird hierauf von den Wirkmolekülen im Zwischenzustand das Licht zweiter Wellenlänge absorbiert, werden die Wirkmoleküle in einen reaktiven Zustand überführt, sodass hierdurch lokal im Ausgangsmaterial 4 im Bereich des jeweiligen Fokusvolumens eine chemische Reaktion ausgelöst wird, insbesondere eine Polymerisation des Ausgangsmaterials 4. Auf diese Weise wird im Bereich des Fokusvolumens eine Materialeigenschaft des Ausgangsmaterials 4 verändert. Insbesondere kann das Ausgangsmaterial 4 im Fokusvolumen so gehärtet oder ausgehärtet werden. Beim Herstellen des dreidimensionalen Objekts wird das Fokusvolumen also der räumliche Überlappungsbereich zwischen dem Licht erster Wellenlänge und dem Licht zweiter Wellenlänge im Fokus des Objektivs 12 gesteuert durch das Ausgangsmaterial 4 im Aufnahmevolumen 5 verlagert, sodass nach und nach Teile des Ausgangsmaterials 4 optisch bearbeitet werden, um so den dreidimensionalen Körper oder das Objekt herzustellen.

In einem Beispiel kann als Lichtquelle 2, 3 für das Strahlbündel der ersten Wellenlänge und zweiten Wellenlänge (λ₁, λ₂) eine Laserlichtquelle genutzt werden, zum Beispiel ein pulsbarer Single-Mode Diodenlaser (Fabrikat IBEAM SMART, Toptica Photonics AG) mit einer Wellenlänge von 375 nm (λ₁) und 515 nm (λ₂). Eine maximale Ausgangsleistung beider Laser beträgt zum Beispiel 100 mW im Dauerstrichbetrieb. Beide Laserstrahlen können jeweils einen räumlichen Filter (Model M-900, Newport) durchlaufen (System optischer Komponenten 6, 7), aufweisend ein Objektiv (Model M-20x, Newport) und eine 10 µm Lochblende (900PH-10, Newport), um ein ideales Gaußförmiges Strahlprofil zu erzeugen. Eine dahinterliegende konvexe Linse kann jeden Laserstrahl auf einen Durchmesser von etwa 5 bis 10 mm kollimieren. Der Halbwellen-Retarder (HWP) 6a, 7a in jedem Strahlengang erlaubt die Rotation des linear polarisierten Laserlichts. Zur Anwendung kommen können beispielweise die Modelle WPHSM05-405, Thorlabs für λ₁ und WPHSM05-514, Thorlabs für λ₂.

Alternativ können die Lichtquellen 2, 3 mit thermischen Lichtquellen wie Glühlampen oder nicht-thermischen Lichtquellen wie LED, Entladungslampen oder Laser gebildet sein.

Als Aperturblende 6c, 7c oder für die Erzeugung einer hälftig beleuchteten Apertur können Rasierklingen verwendet werden, die bis zur Hälfte in den Strahlengang jedes Strahlbündels eingeführt werden. Zur Vereinigung beider Strahlbündel kann der Strahlkombinierer 8 mit einem dichroitischen Spiegel (Modell: DMLP425, Thorlabs) gebildet sein. Ein 4-f Teleskop mit einer Vergrößerung von 1.0 bildet die Aperturblenden in die Eingangspupille 11 des Objektivs 12 (Modell Plan-Apochromat 100x / 1.4 Oil DIC M27, Zeiss AG) ab. Das Objektiv 12 kann Bestandteil eines Auflicht-Mikroskops sein (zum Beispiel Modell: RMA 5, Askania Mikroskop Technik Rathenow GmbH). Für die Bewegung des Fokus im Ausgangsmaterial 4 zum Prozessieren von 3-dimensionalen Strukturen dient zum Beispiel ein xyz-Positioniertisch (Modell: P-545.3R7, Plnano, Physik Instrumente (PI) GmbH & Co. KG). Die Beobachtung der Prozessierung des Ausgangsmaterials erfolgt im Durchlichtstrahlengang des Mikroskops 16. Ein Bandpassfilter (Modell: FB450-40, Thorlabs) oberhalb der Lichtquelle des Mikroskops 16 sorgt dafür, dass der Zwei-Farben-Photoinitator im Ausgangsmaterial 4 durch das Licht des Beobachtungsstrahlengangs nicht angeregt wird.

Zur Strahlfilterung, -führung und -aufweitung in den Systemen optischer Komponenten 6 und 7 können alternativ oder ergänzend optische Fasern mit entsprechenden Ein- und Auskoppeloptiken verwendet werden. Für die Vereinigung der Strahlen des Lichts erster und zweiter Wellenlänge im Strahlkombinierer 8 können anstelle eines dichroitischen Spiegels auch Spiegel, Strahlteilerwürfel und / oder andere wellenlängensensitive Strahlkombinierer verwendet werden.

Für die Bewegung des Fokus im Ausgangsmaterial 4 zum Herstellen des dreidimensionalen Objekts kann anstelle eines xyz-Piezotisch auch ein einachsiger z-Lineartisch in Kombination mit einem zweiachsigen x,y optischen Scannersystem verwendet werden, der vor dem Strahlteiler 10 eingesetzt wird. Das Scannersystem kann als Galvanometer basierte verstellbare Spiegel ausgeführt sein.

Zur Aufprägung einer ortsabhängigen Polarisation über die Querschnittsfläche des Lichtstrahls und zur Änderung der Ausbreitungsrichtung des Lichtstrahls für jede Wellenlänge kann ein Wellenfrontdeformator 6b, 7b eingesetzt werden (vgl. Fig. 1). Dieser kann als steuerbarer Spatial-Light-Modulator (SLM) basierend auf Liquid Crystal Devices (LCD), Liquid Crystal on Silicon (LCOS) oder als Digital-Micromirror-Device (DMD) ausgeführt sein. Die Implementation spezifischer Wellenfrontdeformatoren kann wahlweise den Einbau zusätzlicher Strahlführungsoptiken wie Spiegel und Linsen vorsehen. Eine alternative Möglichkeit ist die Verwendung segmentierter Verzögerungsplatten, beispielsweise Vortex Retarder oder Spiral Phase Plates. Weiterhin können Kombinationen von zwei oder mehr Verzögerungsplatten unterschiedlichen Durchmessers genutzt werden, um in der Querschnittsfläche des Lichtstrahls in einem inneren Ring eine lineare Polarisation erster Orientierung und in einem äußeren Ring eine lineare Polarisation zweiter Orientierung zu erzeugen.

Zur Veränderung des Intensitätsprofils der Querschnittsfläche beider Lichtstrahlen können die Aperturen auch ausgeführt sein als steuerbare Spatial Light Modulators (SLM) basierend auf Liquid Crystal Devices (LCD), Liquid Crystal on Silicon (LCOS) oder Digital MircromirrorDevices (DMD), alternativ auch als nicht steuerbare binäre Masken, diffraktive optische Elemente (DOE) oder Verlaufsfilter sowie eine Kombination mehrerer dieser Elemente.

Die räumlich getrennte Führung und Leitung der Lichtstrahlen erster und zweiter Wellenlänge ermöglicht es, die Ausdehnung des Anregungsvolumens in dem Ausgangsmaterial 4 auf den Überlappungsbereich der beiden Lichtstrahlen im Fokusvolumen zu begrenzen. Wirkmoleküle werden zunächst mit Licht einer ersten Wellenlänge in den aktivierten Zwischenzustand überführt. Aus diesem aktivierten Zwischenzustand kann durch Absorption von Licht der zweiten Wellenlänge das Wirkmolekül in eine aktive (reaktive) Form überführt werden.

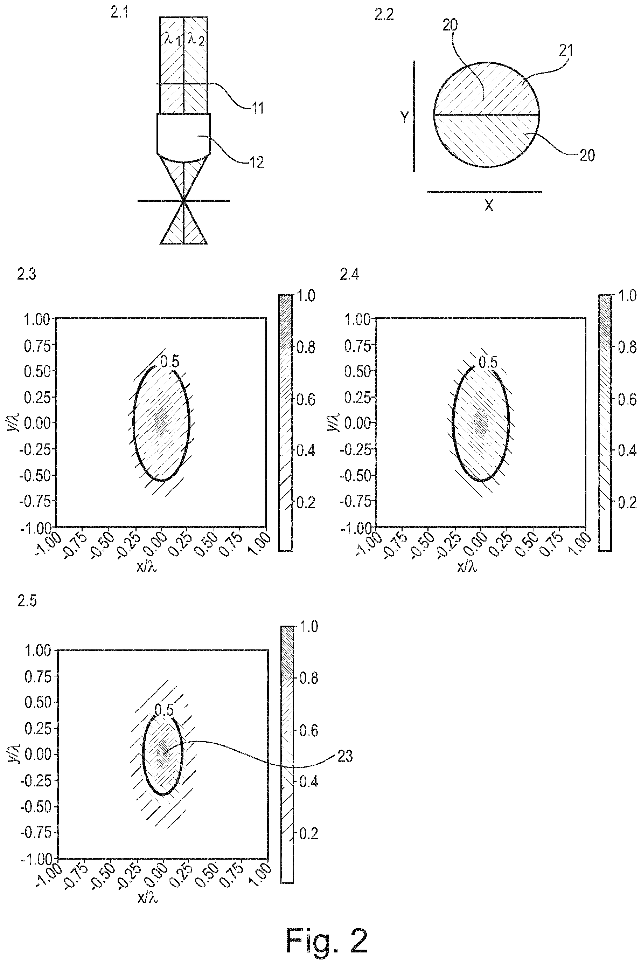

Gemäß einem ersten Ausführungsbeispiel nach den Fig. 2.1 bis 2.5 erfassen das Licht erster Wellenlänge und das Licht zweiter Wellenlänge eine Öffnung 20 der Eintrittspupille 11 jeweils hälftig in Halbkreisbereichen 21, 22 (vgl. Fig. 2.2). Beide Teilstrahlen unterschiedlicher Wellenlänge treten durch die Öffnung 20 mit einfach linearer Polarisation in y-Richtung. Fig. 2.3 und 2.4 zeigen den jeweiligen Fokusbereich für das Licht erster Wellenlänge (Fig. 2.3) und das Licht zweiter Wellenlänge (Fig. 2.4). Fig. 2.5 zeigt den verkleinerten Fokusbereich 23, in welchem die Anregung des Ausgangsmaterials 4 in den reaktiven Zustand lokal stattfindet.

Die Effektivität der Anregung aus dem Zwischenzustand durch das Licht der zweiten Wellenlänge kann von dessen Polarisationsrichtung mit Bezug auf die Polarisationsrichtung der ersten Wellenlänge abhängen. Ein solcher Effekt ist an sich bekannt (vgl. Ramos-Garcia et al., Optical and Quantum Electronics, Vol. 35, 641-650, 2003). Eine effektive Anregung wurde zum Beispiel beobachtet, wenn die Polarisationsrichtungen von erster und zweiter Wellenlänge kollinear (in der Ebene parallel) zueinander sind, wohingegen die Anregung bei senkrecht zueinanderstehender Richtung geringer war. Quantitativ betrachtet ist die Absorptionswahrscheinlichkeit aus dem Zwischenzustand bei diesem Beispiel proportional zu cos²(θ). θ ist hierbei der Winkel zwischen den Polarisationsrichtungen von erster und zweiter Wellenlänge.

Um den Polarisationseffekt zur weiteren Verbesserung des Verfahrens, im Sinne der Verringerung des Anregungsvolumens unterhalb der Beugungsgrenze, zum optischen Bearbeiten zu nutzen, kann dem Licht erster Wellenlänge eine ortsabhängige Polarisation aufgeprägt werden, wodurch sich eine Polarisationsstrukturierung eines der beiden Fokuspunkte unterhalb seiner Ausdehnung ergibt, die durch die Beugungsgrenze limitiert ist. Das Licht des anderen Teilstrahls mit der zweiten Wellenlänge wird entweder ortsunabhängig, in einfacher Form beispielsweise linear polarisiert oder ebenfalls geeignet ortsabhängig polarisiert kodiert.

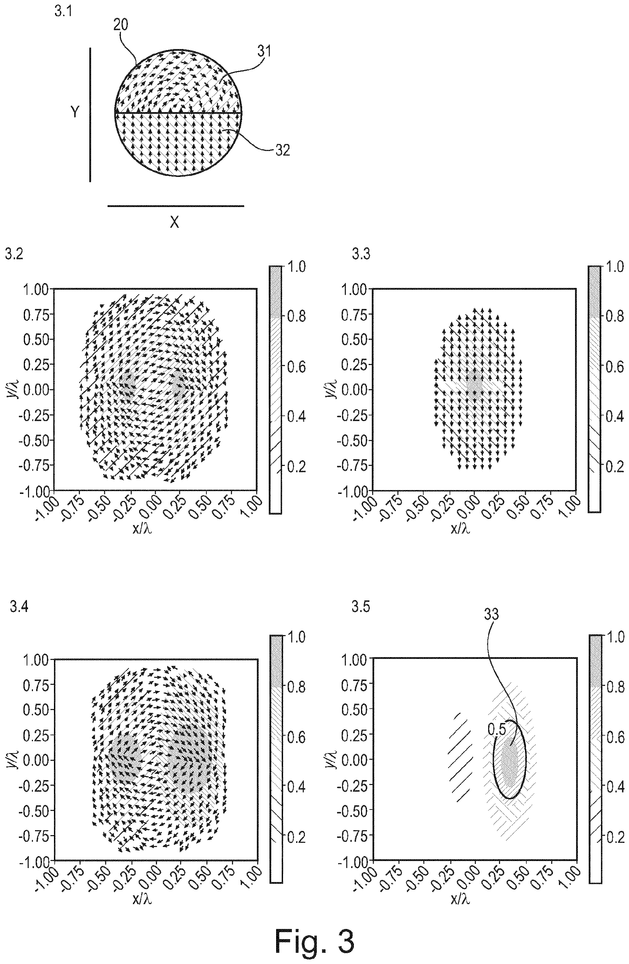

Ein Beispiel ist in den Fig. 3.1 bis 3.5 gezeigt. In diesem Fall wird einem Lichtstrahl 31 räumlich homogener Intensität der ersten Wellenlänge eine ortsabhängige Polarisation aufgeprägt. Der Lichtstrahl erster Wellenlänge 31 erfasst die Öffnung 20 der Eintrittspupille 11 gemäß Fig. 3.1 hälftig. Die Polarisation ist in diesem Fall gegeben durch Eₓ=sin(θ), Eₓ=-cos(θ), der Polarwinkel θ rotiert in der Ebene der Eintrittspupille 11. Der Koordinatenursprung liegt im Zentrum der kreisförmigen Eintrittspupille 11. Ein zweiter Lichtstrahl 32 mit räumlich homogener Intensitätsverteilung zweiter Wellenlänge ist ortsunabhängig in einfacher Form in y-Richtung (Eₓ=0, E_{y}=1) polarisiert. Die Intensitäts- und Polarisationsverteilung in der Fokusebene des Objektivs 12 hängt in nicht-trivialer Weise von der Verteilung in der Eintrittspupille 11 des Objektivs 12 ab und lässt sich über das Debye-Wolf Integral berechnen.

Der Zwei-Farben-Fotoinitiator wird durch den Lichtfokus der ersten Wellenlänge in den Zwischenzustand überführt. Die Anregung ist proportional der lokalen Lichtintensität innerhalb des Fokus. Es werden weiterhin vorwiegend nur die Moleküle des Fotoinitiators angeregt, die so orientiert sind, dass deren Absorptionsdipolmoment in Richtung gerade der lokal gestrahlten Polarisationsrichtung entspricht. Somit wird die eingestrahlte Polarisationsverteilung des Lichtfokus der ersten Wellenlänge auf das Molekülensemble übertragen (vgl. Fig. 3.2 und 3.3).

Mit dem überlagernden Lichtfokus der zweiten Wellenlänge werden nur die Moleküle, die sich im Zwischenzustand befinden, angeregt und in die aktive Form überführt (Fig. 3.4 und 3.5). Die Effektivität dieser zweiten Anregung ist abhängig einerseits von der lokalen Intensität der zweiten Wellenlänge und andererseits von der relativen Orientierung der Polarisationsrichtung der zweiten Wellenlänge im Vergleich zur ersten Wellenlänge. Dies führt zu einer charakteristischen Verkleinerung des Anregungsvolumens, welches aus der Intensitätsund Polarisationsverteilung der beiden Teilstrahlen 31, 32 resultiert. Fig. 3.5 zeigt den verkleinerten Anregungsbereich 33 schematisch im Querschnitt. Durch eine horizontale Verschiebung des Fokus der zweiten Wellenlänge innerhalb der Fokalebene lässt sich die Anregung auf nur einen Punkt begrenzen, wobei die horizontale Ausdehnung unterhalb der Beugungsgrenze liegt. Im gezeigten Beispiel bleibt die Auflösung in vertikaler Richtung unverändert.

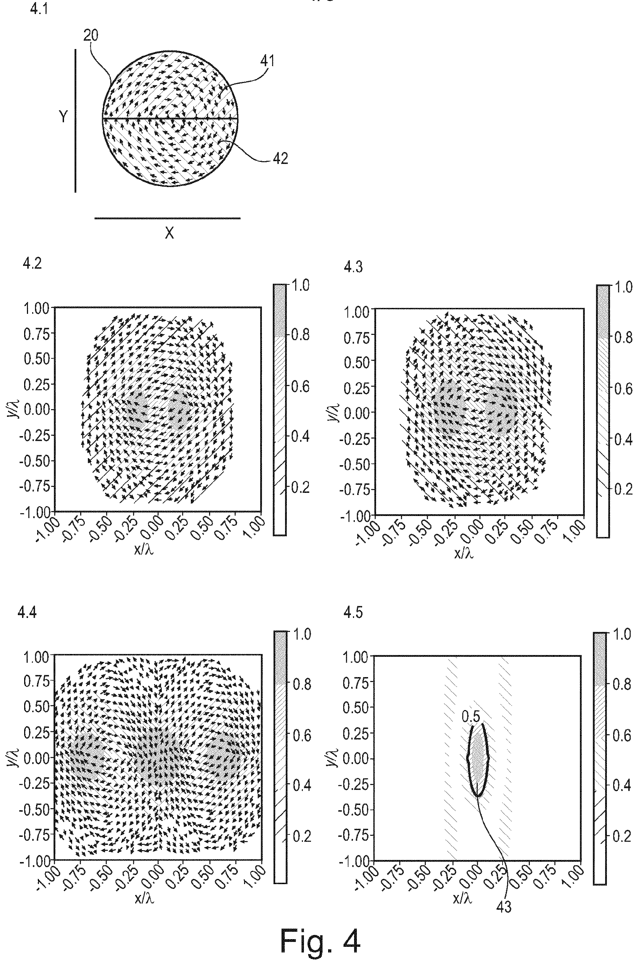

Ein weiteres Beispiel ist in Fig. 4.1 bis 4.5 gezeigt. Hier wird beiden eingestrahlten Lichtstrahlen 41, 42 eine ortsabhängige, rotierende Polarisation aufgeprägt (vgl. Fig. 4.1). Für jeden Lichtstrahlen 41, 42 der ersten und zweiten Wellenlänge ergibt sich eine Intensitäts- und Polarisationsverteilung in der Fokusebene (vgl. Fig. 4.2 und 4.3). Durch horizontale Verschiebung beider Fokuspunkte zueinander (vgl. Fig. 4.4) wird ein verkleinertes Anregungsvolumen 43 (Fokusvolumen) des Fotoinitiators erzeugt (vgl. Fig. 4.5). Das Anregungsvolumen 43 (Fokusvolumen) kann hierbei gleich oder kleiner der Beugungsgrenze für die beiden Wellenlängen sein. Auch in horizontaler Richtung erfolgt eine Verkleinerung.

Durch eine gesteuerte dreidimensionale (3D) Führung des Fokusvolumens (verkleinerter Anregungsbereich) im Ausgangsmaterial 4, insbesondere durch Abrasterung, können vertikale (y-Richtung) Linien mit der geringeren Ausdehnung des Anregungsvolumens in horizontaler Richtung erzeugt werden, zum Beispiel zur Erzeugung von Beugungsgittern.

Für die Erzeugung horizontaler (x-Richtung) Linien mit geringer Ausdehnung, kann die Teilung der Öffnung 20 der Eintrittspupille 11 um 90 Grad gedreht werden, so dass eine vertikale hälftige Teilung erfolgt.

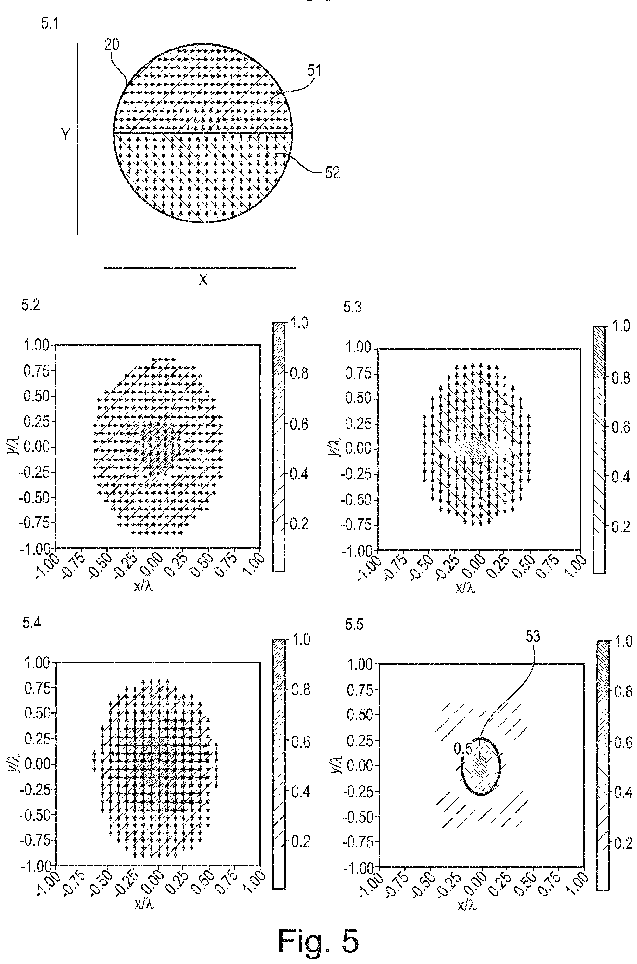

Ein weiteres Beispiel ist in den Fig. 5.1 bis 5.5 dargestellt. Hier wird einem der beiden hälftig eingestrahlten Lichtstrahlen 51 erster Wellenlänge eine ortsabhängige Polarisation aufgeprägt, bei dem ausgehend vom Zentrum ein innerer Halbkreis in y-Richtung und der verbleibende äußere Halbkreis in x-Richtung polarisiert ist. Der andere hälftig eingestrahlte Lichtstrahl 52 zweiter Wellenlänge ist in einfacher Form in y-Richtung polarisiert (vgl. Fig. 5.1).

Für jeden Lichtstrahl 51, 52 der ersten und zweiten Wellenlänge ergibt sich eine Intensitätsund Polarisationsverteilung in der Fokusebene (vgl. Fig. 5.2 und 5.3). Die resultierende Überlagerung beider Fokuspunkte ist in Fig. 5.4 dargestellt. In Zusammenwirkung mit dem Zwei-Farben-Fotoinitiator kann ein Anregungsvolumen 53 des aktiv wirksamen Fotoinitiators gemäß Fig. 5.5 sowohl in vertikaler als auch in horizontaler Richtung unterhalb des Beugungslimits verringert werden.

Mittels des beschriebenen optischen Bearbeitens kann in dem Ausgangsmaterial 4 eine polychrome Mehrphotonen-Polymerisation ("xolography") ausgelöst werden, welche die Veränderung wenigstens einer Materialeigenschaft des Ausgangsmaterials 4 bewirkt. Bei einer beispielhaften Ausgestaltung kann das Ausgangsmaterial 4 wie folgt zusammengesetzt sein:

| Stoff | Strukturformel | Anteil an zum Beispiel 27,1g Ausgangsmaterial insgesamt |
|---|---|---|
| Zwei-Farben-Fotoinitiator | 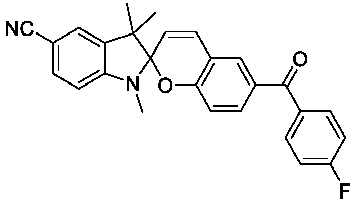 | 2 mg |
| Pentaerythritoltetraacrylate (Monomer) | 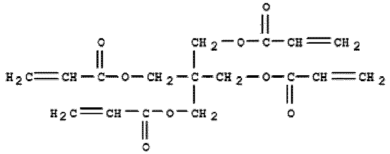 | 25,6g (21,5 ml) |
| Triethanolamin | 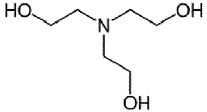 | (0,73g (1 ml) |
| Ethanol | 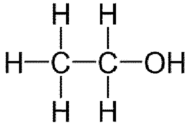 | (0,79g (1 ml) |

Mit der beschriebenen Technologie lässt sich das Ausgangsmaterial 4 unter Verwendung von Zwei-Farben-Fotoinitiatoren mittels Einstrahlen von Licht mit zwei unterschiedlichen Wellenlängen bis hin zum Nanometerbereich dreidimensional strukturieren. Hierzu wird die Öffnung 20 der Eintrittspupille 11 des das eingestrahlte Licht fokussierenden Objektivs 12 in zwei separate Zonen aufgeteilt. Durch jede Zone tritt nur das Strahlbündel einer Wellenlänge. Die Teilung der typischerweise kreisförmigen Öffnung 20 der Eintrittspupille 11 des Objektivs 12 ist beliebig wählbar. In einer Ausführung kann eine Teilung in zwei halbkreisförmige Zonen gewählt werden. Die Überlagerung beider fokussierter Strahlbündel findet nur in der Fokusebene statt, wodurch die Anregung des Zwei-Farben-Fotoinitiators durch Absorption beider Lichtwellen nur dort stattfindet.

Um eine höhere Auflösung zu erreichen, kann ein Strahlbündel mit einer ortsvariablen Polarisation beaufschlagt werden, wodurch in der Fokusebene des Objektivs 12 eine Polarisationsstrukturierung unterhalb der Beugungsgrenze des Fokuspunktes erzeugt wird. Das Strahlbündel der zweiten Wellenlänge wird entweder einfach linear polarisiert oder ebenfalls mit einer ortsvariablen Polarisation beaufschlagt. Die Polarisationsverteilung der zweiten Wellenlänge wirkt hierbei wie ein Analysator für die Verteilung der ersten Wellenlänge und sorgt in Zusammenwirkung mit dem Zwei-Farben-Fotoinitiator für eine Verringerung des Anregungsvolumens unterhalb der Beugungsgrenze der einzelnen Fokuspunkte jeder Wellenlänge.

## Patentansprüche

1. Verfahren zum Herstellen eines dreidimensionalen Objekts in einem optisch reaktiven Ausgangsmaterial, mit:
- Bereitstellen eines optisch reaktiven Ausgangsmaterial (4) in einem Arbeitsvolumen (5), wobei das optisch reaktive Ausgangsmaterial (4) Wirkmoleküle eines Zwei-Farben-Fotoinitiators enthält; und
- optisches Bearbeiten des Ausgangsmaterials (4) zum Herstellen eines dreidimensionalen Objekts in dem Arbeitsvolumen (5) mittels Einstrahlen von Licht einer ersten Wellenlänge und Licht einer zweiten Wellenlänge, die von der ersten Wellenlänge verschieden ist, wobei das Licht erster Wellenlänge und das Licht zweiter Wellenlänge von einer Beleuchtungseinrichtung (1) bereitgestellt werden und das optische Bearbeiten Folgendes umfasst:
a) Einstrahlen des Lichts erster Wellenlänge durch eine Öffnung (20) einer einem Objektiv (12) vorgelagerten Eintrittspupille (11) und das Objektiv (12) hindurch, wobei das Objektiv (12) das Licht erster Wellenlänge in dem Ausgangsmaterial in ein Fokusvolumen in einem Fokus des Objektivs (12) fokussiert, so dass Wirkmoleküle, die das Licht erster Wellenlänge absorbieren, in einen Zwischenzustand übergehen;
b) Einstrahlen des Lichts zweiter Wellenlänge über die Eintrittspupille (11) und das Objektiv (12), wobei das Objektiv (12) das Licht zweiter Wellenlänge in dem Ausgangsmaterial (4) in das Fokusvolumen fokussiert, so dass innerhalb des Fokusvolumens Wirkmoleküle, die in dem Zwischenzustand sind und das Licht zweiter Wellenlänge absorbieren, in einen reaktiven Zustand übergehen und hierdurch in dem Fokusvolumen eine chemische Reaktion ausgelöst wird, durch die eine Materialeigenschaft des Ausgangsmaterial (4) lokal verändert wird; und
c) Herstellen des dreidimensionalen Objekts, indem die Schritte a) und b) für weitere Fokusvolumen, die von dem Fokusvolumen verschieden sind, wiederholt werden;
wobei das Licht erster Wellenlänge und das Licht zweiter Wellenlänge beim Einstrahlen auf dem Weg zum Fokusvolumen hin zumindest beim Durchgang durch die Eintrittspupille (11) und beim Durchgang durch das Objektiv (12) räumlich nicht überlappend und in dem Fokusvolumen räumlich überlappend eingestrahlt werden.

2. Verfahren nach Anspruch 1, **dadurch gekennzeichnet, dass** das Licht erster Wellenlänge und das Licht zweiter Wellenlänge eine Öffnungsfläche der Öffnung der Eintrittspupille jeweils etwa hälftig ausfüllend eingestrahlt werden.

3. Verfahren nach Anspruch 1 oder 2, **dadurch gekennzeichnet, dass** das Licht erster Wellenlänge und das Licht zweiter Wellenlänge eine Querschnittsfläche eines Lichtdurchgangs des Objektivs (12) jeweils etwa hälftig ausfüllend eingestrahlt werden.

4. Verfahren nach mindestens einem der vorangehenden Ansprüche, **dadurch gekennzeichnet, dass** das Licht erster Wellenlänge als polarisiertes Licht erster Wellenlänge eingestrahlt wird.

5. Verfahren nach mindestens einem der vorangehenden Ansprüche, **dadurch gekennzeichnet, dass** das Licht zweiter Wellenlänge als polarisiertes Licht zweiter Wellenlänge eingestrahlt wird.

6. Verfahren nach Anspruch 5 oder 6, **dadurch gekennzeichnet, dass** das Licht erster Wellenlänge und / oder das Licht zweiter Wellenlänge mit einer ortsabhängigen Polarisation eingestrahlt wird.

7. Verfahren nach mindestens einem der vorangehenden Ansprüche, **dadurch gekennzeichnet, dass** das Licht erster Wellenlänge und / oder das Licht zweiter Wellenlänge mit einer räumlich im Wesentlichen homogenen Intensitätsverteilung in das Fokusvolumen eingestrahlt wird.

8. Verfahren nach mindestens einem der vorangehenden Ansprüche, **dadurch gekennzeichnet, dass** das Licht erster Wellenlänge und / oder das Licht zweiter Wellenlänge als gepulstes Licht eingestrahlt werden.

9. Verfahren nach mindestens einem der vorangehenden Ansprüche, **dadurch gekennzeichnet, dass** das Ausgangsmaterial beim optischen Bearbeiten aufgrund der chemische Reaktion zumindest im Bereich des Fokusvolumens sowie der weiteren Fokusvolumen ausgehärtet oder gehärtet wird.

10. Verfahren nach mindestens einem der vorangehenden Ansprüche, **dadurch gekennzeichnet, dass** die durch die Wirkmoleküle im reaktiven Zustand ausgelöste chemische Reaktion eine polychrome Mehrphotonen-Polymerisation aufweisend ausgeführt wird.

11. Vorrichtung zum Herstellen eines dreidimensionalen Objekts in einem optisch reaktiven Ausgangsmaterial, mit:
- einem Arbeitsvolumen (5), welches eingerichtet ist, ein optisch reaktives Ausgangsmaterial (4) aufzunehmen, wobei das optisch reaktive Ausgangsmaterial (4) Wirkmoleküle eines Zwei-Farben-Fotoinitiators enthält;
- einer Beleuchtungseinrichtung (1), die eingerichtet ist, Licht einer ersten Wellenlänge und Licht einer zweiten Wellenlänge, die von der ersten Wellenlänge verschieden ist, zum Einstrahlen auf das Arbeitsvolumen (5) bereitzustellen;
- einem Objektiv (12), welches eingerichtet ist, das Licht erster Wellenlänge und das Licht zweiter Wellenlänge in ein Fokusvolumen in einem Fokus des Objektivs (12) in dem optisch reaktive Ausgangsmaterial (4) einzustrahlen; und
- einer Eintrittspupille (11), welche dem Objektiv (12) in Lichteinfallsrichtung vorgelagert ist, derart, dass das Licht erster Wellenlänge und das Licht zweiter Wellenlänge durch eine Öffnung (20) der Eintrittspupille (11) zu dem Objektiv (12) gelangen;
wobei das Licht erster Wellenlänge und das Licht zweiter Wellenlänge beim Einstrahlen auf dem Weg zum Fokusvolumen hin zumindest beim Durchgang durch die Eintrittspupille (11) und beim Durchgang durch das Objektiv (12) räumlich nicht überlappend und in dem Fokusvolumen räumlich überlappend einstrahlbar sind und
wobei die Beleuchtungseinrichtung (1), die Eintrittspupille (11) und das Objektiv (12) weiterhin eingerichtet sind, das Ausgangsmaterial (4) in dem Arbeitsvolumen (5) zum Herstellen eines dreidimensionalen Objekts wie folgt optisch zu bearbeiten:
a) Einstrahlen des Lichts erster Wellenlänge durch die Eintrittspupille und das Objektiv (12) hindurch, wobei das Objektiv (12) das Licht erster Wellenlänge in dem Ausgangsmaterial (4) in das Fokusvolumen fokussiert, so dass Wirkmoleküle, die das Licht erster Wellenlänge absorbieren, in einen Zwischenzustand übergehen;
b) Einstrahlen des Lichts zweiter Wellenlänge über die Eintrittspupille (11) und das Objektiv (12), wobei das Objektiv (12) das Licht zweiter Wellenlänge in dem Ausgangsmaterial in das Fokusvolumen fokussiert, so dass innerhalb des Fokusvolumens Wirkmoleküle, die in dem Zwischenzustand sind und das Licht zweiter Wellenlänge absorbieren, in einen reaktiven Zustand übergehen und hierdurch in dem Fokusvolumen eine chemische Reaktion ausgelöst wird, durch die eine Materialeigenschaft des Ausgangsmaterial (4) lokal verändert wird; und
c) Herstellen des dreidimensionalen Objekts, indem die Schritte a) und b) für weitere Fokusvolumen, die von dem Fokusvolumen verschieden sind, wiederholt werden.

## Claims

1. A method of manufacturing a three-dimensional object from an optically reactive starting material, comprising :
- providing an optically reactive starting material (4) in a working volume (5), the optically reactive starting material (4) containing active molecules of a two-color photoinitiator; and
optical treatment of the starting material (4) to produce a three-dimensional object in the working volume (5) by irradiating light of a first wavelength and light of a second wavelength different from the first wavelength, the light of the first wavelength and the light of the second wavelength being supplied by an illumination apparatus (1) and the optical treatment comprising the following:
a) irradiating light of the first wavelength through an aperture (20) of an entrance pupil (11) located upstream of an objective lens (12) and the objective lens (12), the objective lens (12) focusing light of the first wavelength into the starting material in a focusing volume in a focal point of the objective lens (12), so that active molecules which absorb light of the first wavelength pass into an intermediate state;
b) irradiating light of the second wavelength via the entrance pupil (11) and the objective (12), the objective (12) focusing the light of the second wavelength into the starting material (4) in the focusing volume, so that in the focusing volume, the active molecules, which are in the intermediate state and absorb the light of the second wavelength, change to a reactive state and thus trigger, in the focusing volume, a chemical reaction by which a material property of the starting material (4) is locally modified ; and
c) manufacturing the three-dimensional object by repeating steps a) and b) for other focusing volumes, which are different from the focusing volume ;
in which light of the first wavelength and light of the second wavelength, when irradiated on the path to the focusing volume, are irradiated without spatial overlap at least when passing through the entrance pupil (11) and when passing through the objective (12) and with spatial overlap in the focusing volume.

2. Method according to claim 1, **characterized in that** light of the first wavelength and light of the second wavelength are irradiated, each filling approximately half of an aperture surface of the entrance pupil aperture.

3. Method according to claim 1 or 2, **characterized in that** light of the first wavelength and light of the second wavelength are irradiated, each filling approximately half of a cross-sectional area of a light passage of the objective (12).

4. Method according to at least one of the preceding claims, **characterized in that** light of the first wavelength is irradiated as polarized light of the first wavelength.

5. Method according to at least one of the preceding claims, **characterized in that** the light of the second wavelength is irradiated as polarized light of the second wavelength.

6. Method according to claim 5 or 6, **characterized in that** light of the first wavelength and/or light of the second wavelength are irradiated with a location-dependent polarization.

7. Method according to at least one of the preceding claims, **characterized in that** light of the first wavelength and/or light of the second wavelength are irradiated into the focusing volume with an essentially spatially homogeneous intensity distribution.

8. Method according to at least one of the preceding claims, **characterized in that** the light of the first wavelength and/or the light of the second wavelength are irradiated as pulsed light.

9. Method according to at least one of the preceding claims, **characterized in that** the starting material is hardened or tempered during the optical treatment due to the chemical reaction at least in the region of the focusing volume as well as the other focusing volumes.

10. Method according to at least one of the preceding claims, **characterized in that** the chemical reaction triggered by the active molecules in the reactive state is carried out by presenting a polychromatic polymerization with several photons.

11. Device for producing a three-dimensional object from an optically reactive starting material, comprising :
- a working volume (5) adapted to receive an optically reactive starting material (4), the optically reactive starting material (4) containing active molecules of a two-color photoinitiator;
- a lighting device (1) adapted to provide light of a first wavelength and light of a second wavelength, different from the first wavelength, to irradiate the working volume (5);
- a lens (12) adapted to irradiate light of the first wavelength and light of the second wavelength into a focusing volume at a focal point of the lens (12) in the optically reactive starting material (4); and
- an entrance pupil (11) positioned upstream of the objective (12) in the direction of light incidence, so that light of the first wavelength and light of the second wavelength reach the objective (21) through an aperture (20) in the entrance pupil (11);
in which the light of the first wavelength and the light of the second wavelength, when irradiated on the way to the focusing volume, can be irradiated without spatially overlapping at least in their passage through the entrance pupil (11) and in their passage through the objective (12) and spatially overlapping in the focusing volume, and
wherein the illuminator (1), the entrance pupil (11) and the objective (12) are further adapted to optically process the starting material (4) in the working volume (5) to produce a three-dimensional object as follows:
a) irradiation of the light of the first wavelength through the entrance pupil and the objective (12), the objective (12) focusing the light of the first wavelength into the starting material (4) in the focusing volume, so that the active molecules which absorb the light of the first wavelength pass into an intermediate state;
b) irradiation of light of the second wavelength via the entrance pupil (11) and the objective (12), the objective (12) focusing the light of the second wavelength into the starting material in the focusing volume, so that in the focusing volume, the active molecules, which are in the intermediate state and absorb the light of the second wavelength, change to a reactive state and thus trigger, in the focusing volume, a chemical reaction by which a material property of the starting material (4) is locally modified ; and
c) manufacturing the three-dimensional object by repeating steps a) and b) for other focusing volumes that are different from the focusing volume.

## Revendications

1. Procédé de fabrication d'un objet tridimensionnel dans un matériau de départ optiquement réactif, comprenant :
- la fourniture d'un matériau de départ optiquement réactif (4) dans un volume de travail (5), le matériau de départ optiquement réactif (4) contenant des molécules actives d'un photo-initiateur à deux couleurs ; et
- le traitement optique du matériau de départ (4) pour fabriquer un objet tridimensionnel dans le volume de travail (5) en irradiant de la lumière d'une première longueur d'onde et de la lumière d'une deuxième longueur d'onde différente de la première longueur d'onde, la lumière de la première longueur d'onde et la lumière de la deuxième longueur d'onde étant fournies par un appareil d'éclairage (1) et le traitement optique comprenant ce qui suit :
a) l'irradiation de la lumière de la première longueur d'onde à travers une ouverture (20) d'une pupille d'entrée (11) placée en amont d'un objectif (12) et de l'objectif (12), l'objectif (12) focalisant la lumière de la première longueur d'onde dans le matériau de départ dans un volume de focalisation dans un foyer de l'objectif (12), de telle sorte que les molécules actives qui absorbent la lumière de la première longueur d'onde passent dans un état intermédiaire ;
b) l'irradiation de la lumière de la deuxième longueur d'onde par le biais de la pupille d'entrée (11) et de l'objectif (12), l'objectif (12) focalisant la lumière de la deuxième longueur d'onde dans le matériau de départ (4) dans le volume de focalisation, de telle sorte que, dans le volume de focalisation, les molécules actives, qui sont dans l'état intermédiaire et qui absorbent la lumière de la deuxième longueur d'onde, passent à un état réactif et déclenchent ainsi, dans le volume de focalisation, une réaction chimique par laquelle une propriété matérielle du matériel de départ (4) est modifiée localement ; et
c) la fabrication de l'objet tridimensionnel en répétant les étapes a) et b) pour d'autres volumes de focalisation, qui sont différents du volume de focalisation ;
dans lequel la lumière de la première longueur d'onde et la lumière de la deuxième longueur d'onde, lorsqu'elles sont irradiées sur le trajet vers le volume de focalisation, sont irradiées sans se chevaucher dans l'espace au moins lors de leur passage à travers la pupille d'entrée (11) et lors de leur passage à travers l'objectif (12) et en se chevauchant dans l'espace dans le volume de focalisation.

2. Procédé selon la revendication 1, **caractérisé en ce que** la lumière de la première longueur d'onde et la lumière de la deuxième longueur d'onde sont irradiées en remplissant chacune environ la moitié d'une surface d'ouverture de l'ouverture de la pupille d'entrée.

3. Procédé selon la revendication 1 ou 2, **caractérisé en ce que** la lumière de la première longueur d'onde et la lumière de la deuxième longueur d'onde sont irradiées en remplissant chacune environ la moitié d'une surface de section transversale d'un passage de lumière de l'objectif (12).

4. Procédé selon au moins l'une quelconque des revendications précédentes, **caractérisé en ce que** la lumière de la première longueur d'onde est irradiée sous forme de lumière polarisée de la première longueur d'onde.

5. Procédé selon au moins l'une quelconque des revendications précédentes, **caractérisé en ce que** la lumière de la deuxième longueur d'onde est irradiée sous forme de lumière polarisée de la deuxième longueur d'onde.

6. Procédé selon la revendication 5 ou 6, **caractérisé en ce que** la lumière de la première longueur d'onde et/ou la lumière de la deuxième longueur d'onde sont irradiées avec une polarisation dépendante de l'emplacement.

7. Procédé selon au moins l'une quelconque des revendications précédentes, **caractérisé en ce que** la lumière de la première longueur d'onde et/ou la lumière de la deuxième longueur d'onde sont irradiées dans le volume de focalisation avec une distribution d'intensité essentiellement homogène dans l'espace.

8. Procédé selon au moins l'une quelconque des revendications précédentes, **caractérisé en ce que** la lumière de la première longueur d'onde et/ou la lumière de la deuxième longueur d'onde sont irradiées sous forme de lumière pulsée.

9. Procédé selon au moins l'une quelconque des revendications précédentes, **caractérisé en ce que** le matériau de départ est durci ou trempé lors du traitement optique en raison de la réaction chimique au moins dans la zone du volume de focalisation ainsi que des autres volumes de focalisation.

10. Procédé selon au moins l'une quelconque des revendications précédentes, **caractérisé en ce que** la réaction chimique déclenchée par les molécules actives à l'état réactif est réalisée en présentant une polymérisation polychrome à plusieurs photons.

11. Dispositif pour la fabrication d'un objet tridimensionnel dans un matériau de départ optiquement réactif, comprenant :
- un volume de travail (5) adapté pour recevoir un matériau de départ optiquement réactif (4), le matériau de départ optiquement réactif (4) contenant des molécules actives d'un photo-initiateur à deux couleurs ;
- un appareil d'éclairage (1) adapté pour fournir de la lumière d'une première longueur d'onde et de la lumière d'une deuxième longueur d'onde, différente de la première longueur d'onde, pour irradier le volume de travail (5) ;
- un objectif (12) adapté pour irradier la lumière de la première longueur d'onde et la lumière de la deuxième longueur d'onde dans un volume de focalisation dans un foyer de l'objectif (12) dans le matériau de départ optiquement réactif (4) ; et
- une pupille d'entrée (11) placée en amont de l'objectif (12) dans la direction d'incidence de la lumière, de telle sorte que la lumière de la première longueur d'onde et la lumière de la deuxième longueur d'onde atteignent l'objectif (21) à travers une ouverture (20) de la pupille d'entrée (11) ;
dans lequel la lumière de la première longueur d'onde et la lumière de la deuxième longueur d'onde, lorsqu'elles sont irradiées sur le trajet vers le volume de focalisation, peuvent être irradiées sans se chevaucher dans l'espace au moins lors de leur passage à travers la pupille d'entrée (11) et lors de leur passage à travers l'objectif (12) et en se chevauchant dans l'espace dans le volume de focalisation, et
dans lequel l'appareil d'éclairage (1), la pupille d'entrée (11) et l'objectif (12) sont en outre adaptés pour traiter optiquement le matériau de départ (4) dans le volume de travail (5) pour fabriquer un objet tridimensionnel comme suit :
a) l'irradiation de la lumière de la première longueur d'onde à travers la pupille d'entrée et l'objectif (12), l'objectif (12) focalisant la lumière de la première longueur d'onde dans le matériau de départ (4) dans le volume de focalisation, de telle sorte que les molécules actives qui absorbent la lumière de la première longueur d'onde passent dans un état intermédiaire ;
b) l'irradiation de la lumière de la deuxième longueur d'onde par le biais de la pupille d'entrée (11) et de l'objectif (12), l'objectif (12) focalisant la lumière de la deuxième longueur d'onde dans le matériau de départ dans le volume de focalisation, de telle sorte que, dans le volume de focalisation, les molécules actives, qui sont dans l'état intermédiaire et qui absorbent la lumière de la deuxième longueur d'onde, passent à un état réactif et déclenchent ainsi, dans le volume de focalisation, une réaction chimique par laquelle une propriété matérielle du matériau de départ (4) est modifiée localement ; et
c) la fabrication de l'objet tridimensionnel en répétant les étapes a) et b) pour d'autres volumes de focalisation qui sont différents du volume de focalisation.
